# EUROPEAN PATENT SPECIFICATION

(11) **EP 0 960 420 B1**
(45) Date of publication and mention of the grant of the patent: **16.04.2003**
(21) Application number: 98903186.9
(22) Date of filing: 10.02.1998
(51) Int. Cl.: G11B 33/12, H05K 7/16

(54) **HOUSING**
GEHÄUSE
BOITIER

(30) Priority: 11.02.1997 GB 9702759
(43) Date of publication of application: 01.12.1999
(73) Proprietor: XYRATEX TECHNOLOGY LIMITED, Havant Hampshire PO9 1SA (GB)
(72) Inventor: MUGGERIDGE, Malcolm, Petersfield, Hampshire GU31 4NR (GB); SCICLUNA, Mark, Hampshire PO13 0YT (GB); BOSWELL, Graham, Peter, Southampton, Hampshire SO31 4QU (GB)
(74) Representative: Laight, Martin Harvey
(86) International application number: GB9800417
(87) International publication number: WO98035350

(56) References cited:
- DE-A- 3 523 751
- US-A- 4 800 821
- US-A- 5 124 886

## Description

The present invention relates to a housing for data storage apparatus.

In data storage apparatus, a housing having several bays is provided. Each bay can support a device such as a data storage device (for example, a disk drive), a power supply unit, or a cooling fan, for example. Typical housings are fixed sheet metal boxes which are individually tailored to suit a fixed number of devices. The devices may be arrayed in any suitable manner. Typical layouts have for example three devices in a vertical column, six devices in two adjacent columns of three devices each, nine devices in three columns of three devices each, or twelve devices in four columns of three devices each. In the prior art, it has been necessary to manufacture four distinct housings in order to accommodate these four typical layouts. Other layouts can only be accommodated by housings specifically manufactured for such further layouts.

One possible alternative to the manufacturing of housings for specific layouts is to provide housings which accommodate only a single column of devices, such as a column of three or four disk drives. Such housings are then placed side by side in order to accommodate six (or eight) or further multiples of three (or four) disk drives or other devices. However, the use of multiple box-like housings of this type increases the lateral extent of the box-like housings as the wall thickness is doubled at each junction between adjacent box-like housings of this type. This increase in the wall thickness can be a problem, especially when the housings have to be fitted into a standard rack of width 19" (48.3cm).

In US-A-5,124,886, there is disclosed a modular cabinet for enclosing a plurality of disk drive canisters. The cabinet includes left and right sides and a center section, each formed of molded structural foam. Each side includes horizontal top and bottom portions which include tongue-like projections for mating with similar features in top and bottom portions of the centre section. The sides and centre section are secured together with the use of four latching members which co-operate with features molded into the sides. The design of the components permits easy assembly of the cabinet without the use of tools. Horizontal rails molded into the internal surfaces of the sides and both surfaces of the centre section form the bays for receiving disk drive canisters. However this disclosure shows only a modular cabinet for accommodating two adjacent columns of devices and does not disclose a housing more than two adjacent columns of devices within a continuous modular construction formed from a relatively small number of different shapes of components.

According to a first aspect of the present invention, there is provided a modular housing comprising two side units and an intermediate unit; each side unit comprising a side wall; a first lateral wall extending perpendicular to the side wall at one end thereof; a second lateral wall extending perpendicular to the side wall at the other end thereof and extending in the same direction as the first lateral wall; and connecting means at the distal end of each lateral wall for connecting the side unit to another unit to form a housing, the connecting means comprising first connector means at the distal end of the first lateral wall and second connector means at the distal end of the second lateral wall; the intermediate unit comprising an intermediate wall; a first lateral wall extending perpendicular to the intermediate wall at one end thereof and having a first distal end on one side of the intermediate wall and a second distal end on the other side of the intermediate wall; a second lateral wall extending perpendicular to the intermediate wall at the other end thereof and having a first distal end on the said one side of the intermediate wall and a second distal end on the said other side of the intermediate wall; and connecting means at the distal ends of each lateral wall for connecting the intermediate unit to other units to form a housing, the connecting means comprising first connector means at the first distal end of the first lateral wall, second connector means at the first distal end of the second lateral wall, further second connector means at the second distal end of the first lateral wall, and further first connector means positioned at the second distal end of the second lateral wall; the first and second connector means having co-operating interconnectable shapes such that each first connector means is shaped to be connectable to a second connector means on another unit, and each second connector means is shaped to be connectable to a first connector means on another unit.

The present invention provides a modular housing which need only have two distinct units, namely a side unit and an intermediate unit. Each side unit can be substantially identical. Any number of intermediate units can be positioned between the side units so that the housing can be expanded to accommodate further devices as necessary. Where plural intermediate units are provided, each may be substantially identical. The units can be simply manufactured by extruding aluminium or plastics, for example. The depth of the units can be practically chosen at will as the units can be cut to any length required.

The housing may have a single intermediate unit engaged on one side with the first side unit and on an opposite side with the second side unit.

Alternatively, the housing may have a first intermediate unit engaged on one side with the first side unit and a second intermediate unit engaged on one side with the second side unit, the first and second intermediate units being engaged with each other on their respective second sides.

The housing may have a first intermediate unit engaged on one side with the first side unit, a second intermediate unit engaged on one side with the second side unit, and at least one further intermediate unit between and engaged with the first and second intermediate units.

The side and intermediate walls may define adjacent bays of the housing, each bay being defined between a side wall and an adjacent intermediate wall or between two adjacent intermediate walls where plural intermediate units are provided. The side and intermediate walls may have means defining at least two sub-bays within a bay of the housing for receiving a device each.

Preferably, the thicknesses of each side wall and the or each intermediate wall are substantially the same.

In a most preferred embodiment, the side and intermediate walls define n adjacent bays of the housing, n being an integer greater than 1, each bay being defined between a side wall and an adjacent intermediate wall or between two adjacent intermediate walls, there being n-1 intermediate units, the lateral extent of the housing being n(s+m)+s where the thickness of the first side wall is s, the thickness of the second side wall is s, the thickness of the or each intermediate wall is s, and the separation between two adjacent walls of the housing is m. This allows expansion of the housing by adding further intermediate units without unduly increasing the lateral extent of the housing. In this embodiment, addition of a further intermediate unit increases the width of the housing by m+s, i.e. the thickness of one wall and the width of a spacing provided between adjacent walls of the housing.

At least one of the side walls and intermediate walls preferably has means for supporting a data storage device in the housing.

The connecting means may conveniently comprise a stepped portion of a lateral wall of the intermediate unit for engagement with a corresponding stepped portion of at least one of a wall of the first side unit, the second side unit, and a further intermediate unit between said first intermediate unit and a side unit.

According to a second aspect of the present invention, there is provided a side unit for use with one or more other units to form a housing, the side unit comprising a side wall; a first lateral wall extending perpendicular to the side wall at one end thereof; a second lateral wall extending perpendicular to the side wall at the other end thereof and extending in the same direction as the first lateral wall; connecting means at the distal end of each lateral wall for connecting the side unit to another unit to form a housing; in which the connecting means comprise first connector means at the distal end of the first lateral wall and second connector means at the distal end of the second lateral wall; and the first and second connector means have co-operating interconnectable shapes such that the first connector means is shaped to be connectable to a further second connector means on another unit and the second connector means is shaped to be connectable to a further first connector means on another unit.

According to a third aspect of the invention there is provided an intermediate unit for use with other units to form a housing, the intermediate unit comprising an intermediate wall; a first lateral wall extending perpendicular to the intermediate wall at one end thereof and having a first distal end on one side of the intermediate wall and a second distal end on the other side of the intermediate wall; a second lateral wall extending perpendicular to the intermediate wall at the other end thereof and having a first distal end on the said one side of the intermediate wall and a second distal end on the said other side of the intermediate wall; connecting means at the distal ends of each lateral wall for connecting the intermediate unit to other units to form a housing; in which the connecting means comprise first connector means at the first distal end of the first lateral wall, second connector means at the first distal end of the second lateral wall, further second connector means at the second distal end of the first lateral wall, and further first connector means positioned at the second distal end of the second lateral wall; and each first and second connector means have co-operating interconnectable shapes such that each first connector means is shaped to be connectable to a further second connector means on another unit and each second connector means is shaped to be connectable to a further first connector means on another unit.

In some arrangements in accordance with the invention each connector means comprises a stepped portion of a lateral wall of a unit for engagement with a corresponding stepped portion of a lateral wall of another unit. Preferably the stepped portions of units are shaped to engage stepped portions of adjacent units by overlapping.

Embodiments of the present invention will now be described by way of example with reference to the accompanying drawings, in which:
Figure 1 is a view from one end of a side unit embodying the invention;
Figure 2 is a view from one end of an intermediate unit embodying the invention;
Figure 3A-3D are end views of a housing embodying the invention having two side units, two side units and one intermediate unit, two side units and two intermediate units, and two side units and three intermediate units, respectively;
Figure 4 is an end view of another example of a housing embodying the invention showing devices fitted in the housing;
Figure 5 is an end view of a further example of a housing embodying the invention;
Figure 6 is an end view of a yet further example of a housing embodying the present invention; and
Figures 7 and 8 are diagrammatic perspective views of housings embodying the invention generally corresponding to that shown in Figure 3B, but with modified connecting means.

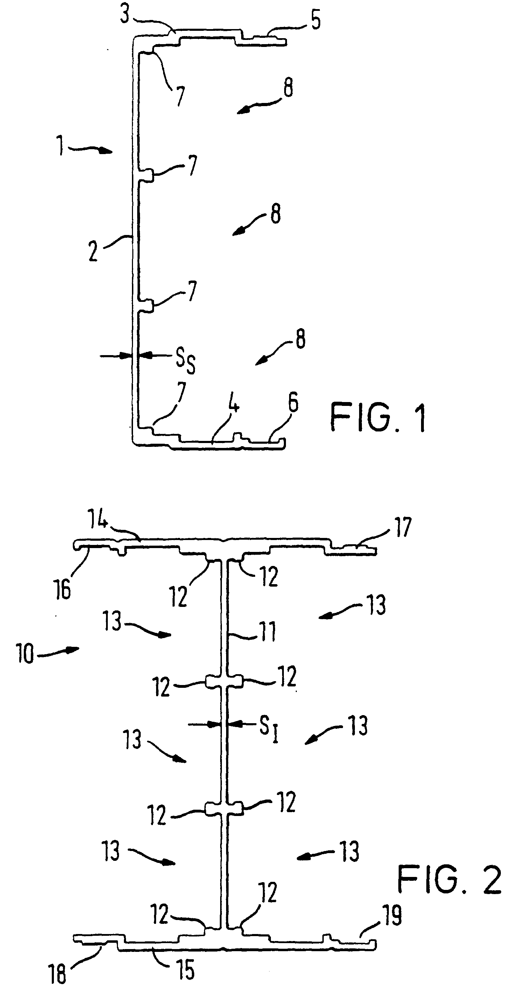

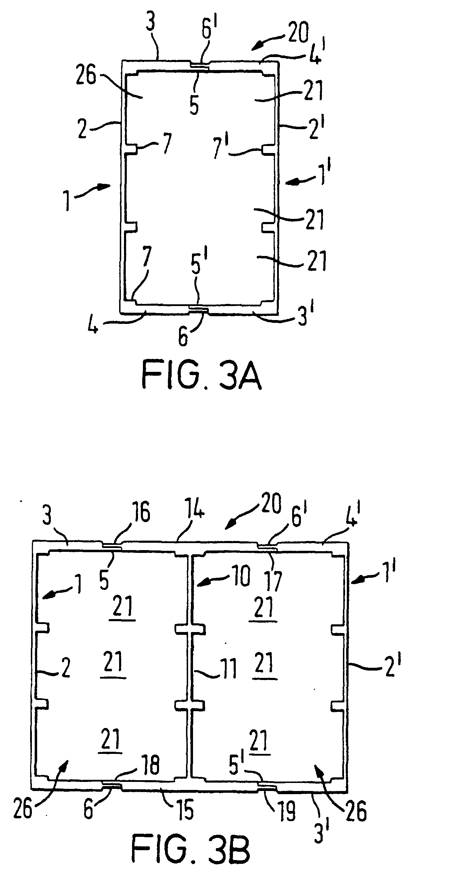

Reference will be made first to Figures 1 and 2 which show respectively a side unit 1 and an intermediate unit 10 for a housing, and to Figures 3A to 3D which show various housings formed from combinations of the side units 1, or the side units 1 and one or more intermediate units 10, embodying the invention.

In Figure 1, there is shown a side unit 1. The side unit generally has a C-shape cross-section. The side unit 1 may be made of extruded aluminium, though other materials and manufacturing techniques, such as extruded or moulded plastics, are possible. The side unit has a wall 2 which, as will be seen, provides a first side wall of a housing which includes such a side unit 1. The side wall 2 has a thickness s. In a particular example, the thickness s_{S} is 2.4mm.

Projecting at right angles to the side wall 2 are further, lateral, walls 3,4 which provide the top and bottom walls of the housing. Each of the top and bottom walls 3,4 terminates in a step 5,6 along its free edge.

Plural runners 7 are provided along the length of the side wall 2 and project into the body of the "C" defined by the side unit 2. In the example shown in Figure 1, there are four runners 7. The top and bottom runners 7 are positioned very close to the top and bottom walls 3,4 and the intermediate runners 7 are spaced equidistantly from the top and bottom runners 7. The four runners 7 therefore divide the side wall 2 into three distinct and equal sized portions 8.

In Figure 2, there is shown an intermediate unit 10, generally of I-shape in cross-section. As will be seen from Figure 3B, the upright of the I-shape intermediate unit 10 can provide an intermediate wall 11 of the housing. The thickness s_{I} of the intermediate wall 11 is preferably the same as that of the side wall 2 of the side unit 1, namely 2.4mm in this example, so as to make best use of the space available.

The intermediate wall 11 has four outwardly facing runners 12 on each side. As with the side unit 2, the runners 12 of the intermediate unit 10 divide the intermediate unit 10 into three equal portions 13 on each side of the intermediate wall 11.

The intermediate unit 10 has further, lateral, walls 14,15 at each end of and perpendicular to the intermediate wall 11. In Figure 3B, for example, these further walls 14,15 of the intermediate unit 10 define with the further walls 3,4 of the side unit 1, the top and bottom housing walls of the housing constructed from such units. Each of the top and bottom lateral walls 14,15 of the intermediate unit 10 has a step 16,17,18,19 along both of its free edges.

The side and intermediate units 1,10 can be combined together in many different configurations to provide housings which have different capacities and layouts for receiving devices. Devices which might be received in the housings include data storage devices such as disk drives, power supply units, cooling fan units, and the like.

As shown in Figure 3A, two identical side units 1,1' can be joined together. The various parts of the side unit 1' are indicated by reference numerals corresponding to those of the side unit 1, but with an inverted comma added. The side units 1, 1' are identical but one is rotated through 180° (inverted) relative to the other. The two identical side units can then be joined with their respective steps 5,6', and 6,5', engaging one another by overlapping to define a bay 26. If desired, the respective side units 1,1' may be fixed together at the engaged steps 5,6';6,5' by welding, gluing, or by some other fastening means such as rivets, screws or the like. In the example shown in Figure 3A, the arrangement of the runners 7 provides three distinct sub-bays 21 each of which can receive a device as mentioned above.

In the example of the invention shown in Figure 3B, two side units 1,1' are separated by a single intermediate unit 10. The steps 5,6 of the first side unit 1 engage with the respective steps 16,18 of the intermediate unit 10. Similarly, the steps 5',6' of the other side unit 1' engage with the corresponding steps 19,17 of the intermediate unit 10. As can be seen from Figure 3B, the housing 20 formed by the two side units 1,1' and the single intermediate unit 10 has two bays 26 defined respectively between the side walls 2,2' and the intermediate wall 11, and between the intermediate wall 11 and the side wall 2', each bay 21 having a width m of 108.6mm in this example. The two bays 26 are divided into three sub-bays 21 each by the runners 7,12 and 7' of the side and intermediate walls 2,11 and 2'.

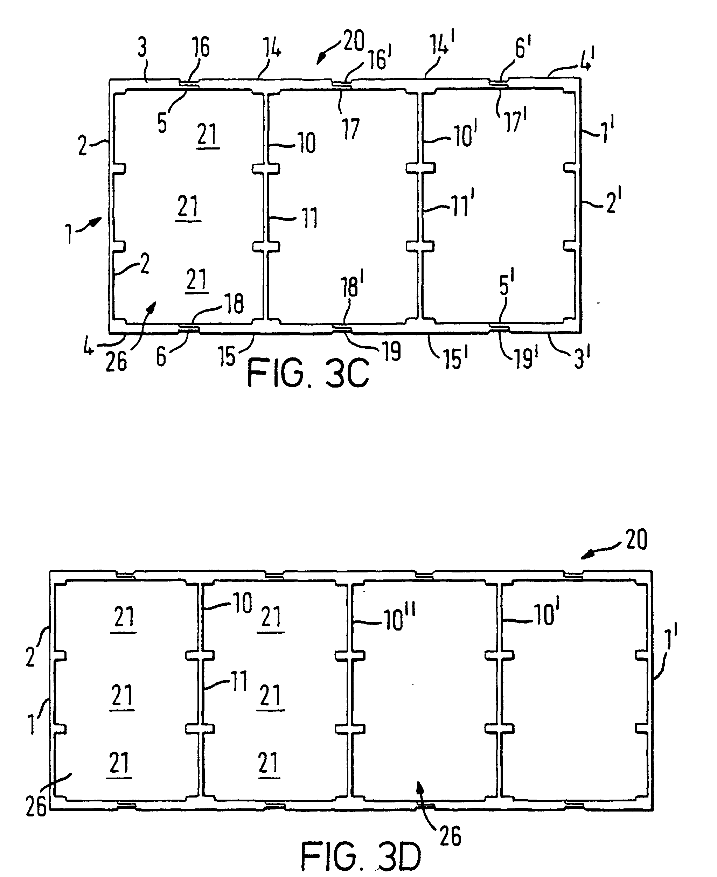

Further examples of housings 20 are shown in Figures 3C and 3D. In the example shown in Figure 3C, the two side units 1,1' are separated by two intermediate units 10,10'. The various parts of the intermediate unit 10' are indicated by reference numerals corresponding to those of the intermediate unit 10, but with an inverted comma added. The two intermediate units 10,10' engage each other at their respective steps 17,16', and 19,18'. In the example shown in Figure 3C, there are three bays 26 divided into three sub-bays 21 each. In the example shown in Figure 3D, the two side units 1,1' are separated by three intermediate units 10, 10' and 10" to provide a housing 20 having four bays 26 of three sub-bays 21 each.

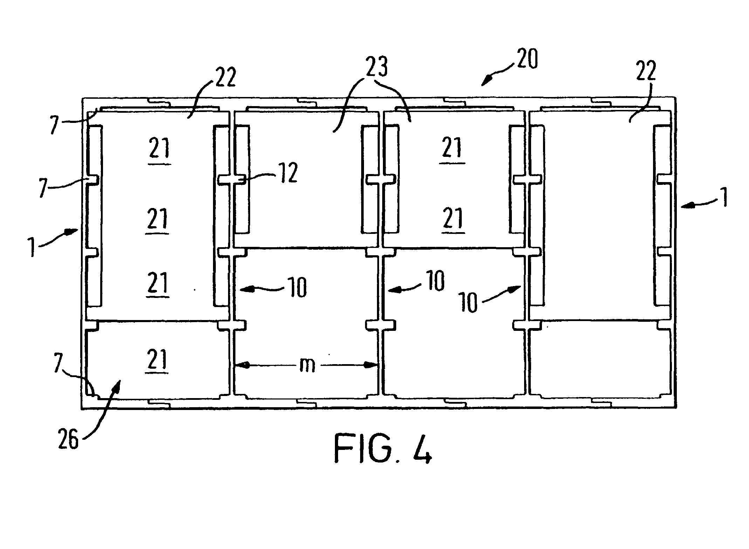

It will be appreciated that more or less sub-bays 21 may be provided in a columnar bay 26 of the housing simply by increasing the height of the side and intermediate units 1,10 and adjusting the number of runners 7,12 accordingly. By way of example, Figure 4 shows a housing 20 having four bays 26 of four sub-bays 21 each formed by two side units 1 and three intermediate units 10. In this example, each side unit 1 and intermediate unit 10 has five runners 7,12 which define the four sub-bays 21 of each bay 26 in the housing 20. Furthermore, Figure 4 shows how power supply units 22 and fans 23 can be received in the housing 20. In the example shown in Figure 4, each power supply unit has a height equivalent to the height of three sub-bays 21 and each fan unit 23 has a height equivalent to the height of two sub-bays 21.

It will be appreciated that, where the separation between adjacent walls in a housing 20 is m, and the walls of the housing have a thickness s, the addition of a further intermediate unit 10 to expand the housing 20 adds a thickness of only (s+m) to the overall width of the housing 20. Thus, the same or substantially the same units 1,10 can be used to form housings of any dimension without any doubling of wall thicknesses when further intermediate units 10 are added. This means that the housing 20 can more easily fit into a standard 19" (48.3cm) rack and it also means that the width m of the bays 26 is not limited or reduced unnecessarily by the width of the walls.

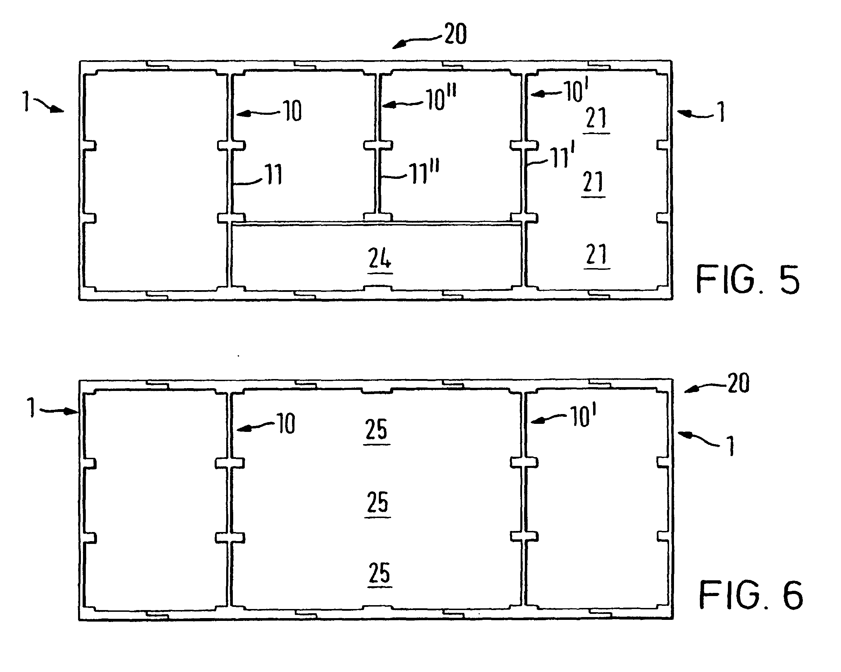

Figures 5 and 6 show further examples of housings 20 in accordance with an embodiment of the present invention. In the example shown in Figure 5, the central intermediate wall 11' provided by the central intermediate unit 10' has been shortened by a length equivalent to the height of one sub-bay 21. This enables a device 24 having a width equal to twice the separation between adjacent walls 11 to be accommodated.

In the example shown in Figure 6, the central intermediate wall 11 is missing altogether so as to create three sub-bays 25 of double width in a column in the centre of the housing 20.

The units in Figures 5 and 6 with shortened or missing intermediate walls 11 may be provided by separate extrusions or mouldings.

The various units 1,10 are preferably made of metal or some other electrically conducting material. Electrical conductivity is maintained at the junctions between connected units 1,10.

Whilst the assembled units 1,10 described above have been shown in the drawings as being orientated laterally, it will be understood that the assembled units 1,10 could be rotated through 90° to create a tower product.

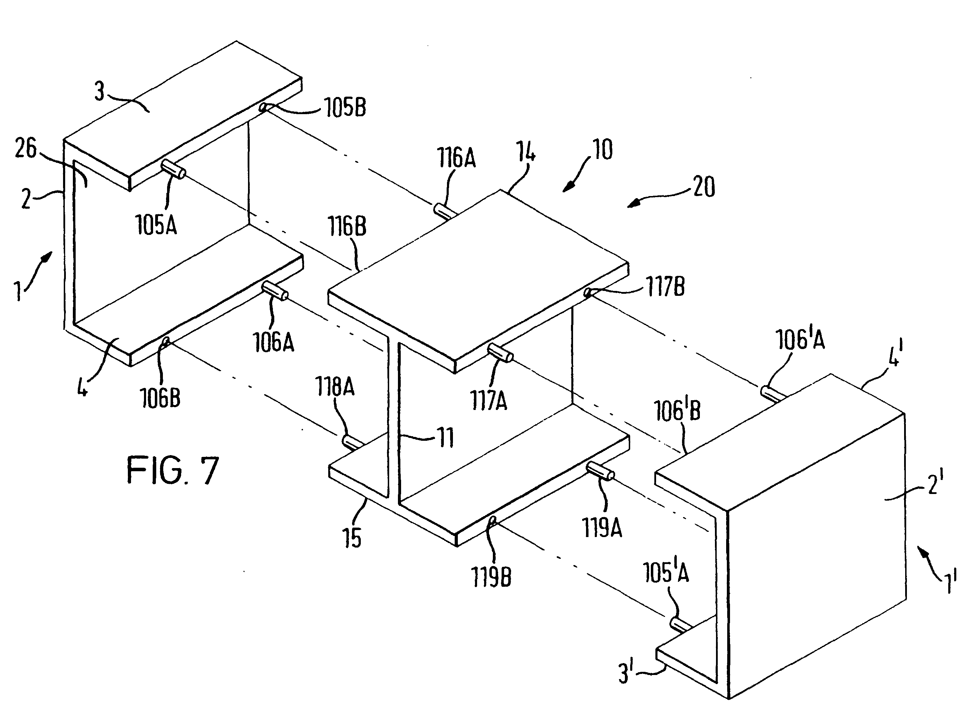

In Figure 7 there is shown a modification of the arrangement shown in Figure 3B, in which the overlapping stepped connector means 5, 6, 16, 18, 17, 19, 6' and 5', are replaced by modified connector means indicated at 105A and B, 106A and B, 116A and B, 118A and B, 117A and B, 119A and B, 106'A and B, and 105'A and B. Other components which correspond to components shown in Figure 3B, are shown by like reference numerals.

In Figure 7, the side unit 1 has upper connector means 105A and 105B consisting of a protruding pin, and circular hole, respectively. The lower connector means comprises a projecting pin 106A and corresponding circular hole 106B, but with the positions of the pin and hole interchanged compared with the upper connector means 105A, 105B. Similarly, the intermediate unit 10 has on its upper wall 14 a projecting pin 116A and a circular hole 116B, which match with the respective hole 105B and pin 105A on the upper wall 3 of the side unit 1. On the side of the intermediate unit 10 facing away from the side unit 1, the upper wall 14 has a protruding pin 117A and corresponding circular hole 117B, and the lower wall 15 has a pin 119A and hole 119B, with the positions interchanged relative to the upper wall 14. The second side unit 1' has corresponding pins and holes 106'A and 105'A, and 106'B and 105'B respectively, which cooperate with the pins and holes on the intermediate unit 10.

The pins may be an integral part of the side and intermediate units if moulded, but can be separately assembled if the units are extruded. The pins and holes can be of cross-section other than circular, for example square, rectangular or triangular.

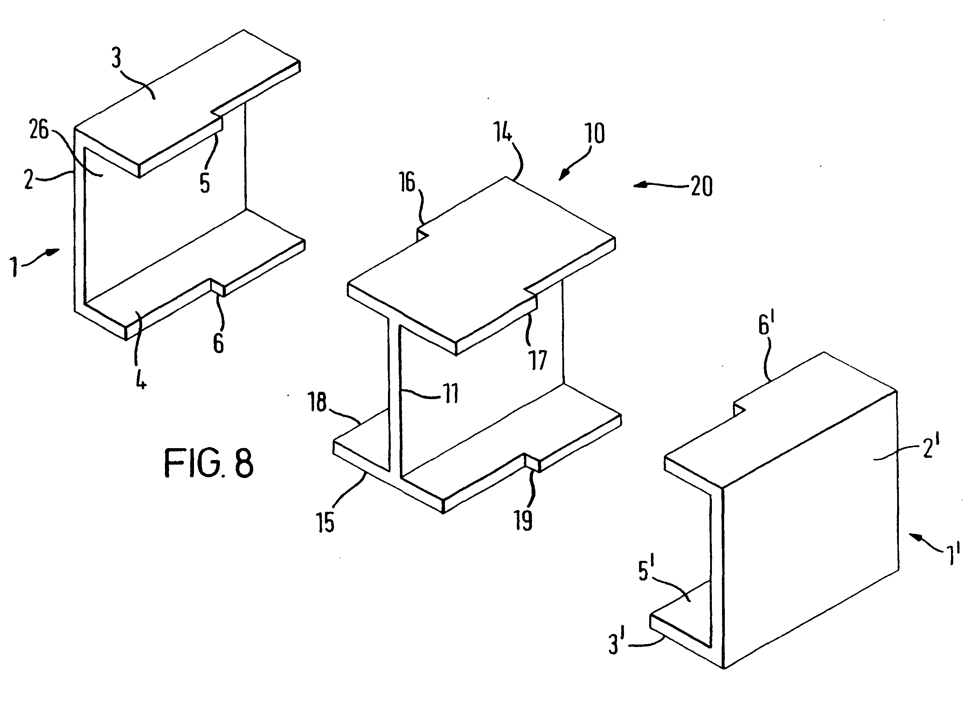

In Figure 8 there is shown a further modification of the arrangement shown in Figure 3B in which the overlapping stepped connector means 5, 6, 16, 18, 17, 19, 6' and 5', are replaced by modified connector means indicated by the same reference numerals. In Figure 8 the connector means comprise abutting portions of the walls 3, 14, 4' and 4, 15, 3'. The distal end of the each lateral wall extends further in one half of the distal end than in the other, the greater and lesser extensions being reversed in position on the upper and lower lateral walls, so that the intermediate unit 10 can be connected optionally, that is to say at the choice of the user, to the first side unit 1 or to the second side unit 1' or to a further intermediate unit (not shown in Figure 8). Each side unit is connectable to another side unit, and is also connectable to an intermediate unit. Each intermediate unit is connectable to another intermediate unit and is also connectable to a side unit.

The present invention provides housings for data storage devices which are modular and which require a minimum number of different units from which the housings are assembled. The units can provide high mechanical strength and provide a high packing density in the assembled housing. There is a minimal encroachment on storage space for devices within the housing and the lateral extent of the housing is also minimised.

One particular advantage of the design of the cooperating connecting means, such as the overlapping joints or cooperating pins and holes, is that, assuming the material used for the units is conductive, then material contact is maintained between the units to provide an electrically conductive path.

Embodiments of the present invention have been described with particular reference to the examples illustrated. However, it will be appreciated that variations and modifications may be made to the examples described within the scope of the present invention as defined in the claims

## Claims

1. A modular housing comprising two side units (1, 1') and an intermediate unit (10);
each side unit (1) comprising:
a side wall (2);
a first lateral wall (3) extending perpendicular to the side wall (2) at one end thereof;
a second lateral wall (4) extending perpendicular to the side wall (2) at the other end thereof and extending in the same direction as the first lateral wall (3); and
connecting means (5; 105A and B; 6; 106A and B) at the distal end of each lateral wall (3) for connecting the side unit (1) to another unit to form a housing (20);
the intermediate unit comprising :
an intermediate wall (11);
a first lateral wall (14) extending perpendicular to the intermediate wall (11) at one end thereof and having a first distal end on one side of the intermediate wall (11) and a second distal end on the other side of the intermediate wall (11);
a second lateral wall (15) extending perpendicular to the intermediate wall (11) at the other end thereof and having a first distal end on the said one side of the intermediate wall (11) and a second distal end on the said other side of the intermediate wall (11); and
connecting means (16; 116A and B; 17; 117A and B; 18; 118A and B; and 19; 119A and B) at the distal ends of each lateral wall (14, 15) for connecting the intermediate unit (10) to other units to form a housing;
**characterised in that** on each side unit the connecting means comprise first connector means (5; 105A and B) at the distal end of the first lateral wall (3) and second connector means (6; 106A and B) at the distal end of the second lateral wall (4); on the intermediate unit the connecting means comprise first connector means (17; 117A and B) at the first distal end of the first lateral wall (14), second connector means (19; 119A and B) at the first distal end of the second lateral wall (15), further second connector means (16; 116A and B) at the second distal end of the first lateral wall (14), and further first connector means (18; 118A and B) positioned at the second distal end of the second lateral wall (15) and the first and second connector means (17; 117A and B; 18; 118A and B; 19; 119A and B; 16; 116A and B) have co-operating interconnectable shapes such that each first connector means (17; 117A and B; 18; 118A and B) is shaped to be connectable to a second connector means on another unit, and each second connector means (19; 119A and B; 16; 116A and B) is shaped to be connectable to a first connector means on another unit.

2. A housing according to Claim 1, wherein each side unit (1, 1') is substantially identical to the other in construction but wherein one side unit is inverted relative to the other.

3. A housing according to Claim 1 or Claim 2, wherein the housing includes at least two intermediate units (10, 10') as defined in Claim 1.

4. A housing according to Claim 3, wherein the intermediate units are substantially identical to each other.

5. A housing according to any of Claims 1 to 3, comprising a first intermediate unit (10) engaged on one side with the first side unit (1) and a second intermediate unit (10') engaged on one side with the second side unit (1'), the first and second intermediate units (10, 10') being engaged with each other on their respective second sides.

6. A housing according to any of Claims 1 to 3, comprising a first intermediate unit (10) engaged on one side with the first side unit (1), a second intermediate unit (10') engaged on one side with the second side unit (1'), and at least one further intermediate unit (10") between and engaged with the first and second intermediate units (10, 10').

7. A housing according to any of Claims 1 to 6, wherein the side and intermediate walls (2, 1') define adjacent bays (26) of the housing (20), each bay (26) being defined between a side wall (2) and an adjacent intermediate wall (11) or between two adjacent intermediate walls (11, 11') where plural intermediate units (10, 10') are provided.

8. A housing according to Claim 7, wherein the side and intermediate walls (2, 11) have means (7, 12) defining at least two sub-bays (21) within a bay (26) of the housing (20) for receiving a device (22, 23, 24) each.

9. A housing according to any of Claims 1 to 8, wherein the thicknesses of each side wall (2, 2') and the or each intermediate wall (11, 11') are substantially the same.

10. A housing according to any preceding claim, wherein the connecting means comprises a stepped portion of a lateral wall (14, 15) of the or each intermediate unit for engagement with a corresponding stepped portion of at least one of a wall of the first side unit (1), a wall of the second side unit (1'), and a wall of a further intermediate unit (10') between said first intermediate unit and a side unit.

11. A housing according to Claim 10, wherein the respective stepped portions of adjacent units engage one another by overlapping.

12. A housing according to any preceding claim, wherein the housing is adapted for housing data storage apparatus.

13. A housing according to any preceding claim, wherein at least one of the side walls and intermediate walls has means (7, 12) for supporting a data storage device in the housing.

14. Data storage apparatus comprising a housing according to any of Claims 1 to 13, and further comprising a data storage device contained in said housing.

15. Apparatus according to Claim 14, wherein the data storage device is a disk drive.

16. A housing according to any preceding claim wherein:
the side wall (2) of the first side unit (1) provides a first side wall (2) of the housing, the side wall (2') of the second side unit (1') provides a second side wall (2') of the housing opposite and substantially parallel to the first housing side wall (2); and the intermediate wall (11) of the or each intermediate unit (10) provides an intermediate wall (11) of the housing between and substantially parallel to the first and second side walls (2, 2').

17. A side unit for use with one or more other units to form a housing, the side unit (1) comprising
a side wall (2);
a first lateral wall (3) extending perpendicular to the side wall (2) at one end thereof;
a second lateral wall (4) extending perpendicular to the side wall (2) at the other end thereof and extending in the same direction as the first lateral wall (3);
connecting means (5,6) at the distal end of each lateral wall (3) for connecting the side unit (1) to another unit to form a housing (20); **characterised in that**
the connecting means comprise first connector means (5; 105A and B) at the distal end of the first lateral wall (3) and second connector means (6; 106A and B) at the distal end of the second lateral wall (4), and
the first and second connector means (5; 105A and B; 6; 106A and B) have co-operating interconnectable shapes such that the first connector means (5; 105A and B) is shaped to be connectable to a further second connector means on another unit and the second connector means (6; 106A and B) is shaped to be connectable to a further first connector means on another unit.

18. An intermediate unit for use with other units to form a housing, the intermediate unit comprising :
an intermediate wall (11);
a first lateral wall (14) extending perpendicular to the intermediate wall (11) at one end thereof and having a first distal end on one side of the intermediate wall (11) and a second distal end on the other side of the intermediate wall (11);
a second lateral wall (15) extending perpendicular to the intermediate wall (11) at the other end thereof and having a first distal end on the said one side of the intermediate wall (11) and a second distal end on the said other side of the intermediate wall (11);
connecting means (16; 116A and B; 17; 117A and B; 18; 118A and B; and 19; 119A and B) at the distal ends of each lateral wall (14, 15) for connecting the intermediate unit (10) to other units to form a housing; **characterised in that**
the connecting means comprise first connector means (17: 117A and B) at the first distal end of the first lateral wall (14), second connector means (19; 119A and B) at the first distal end of the second lateral wall (15), further second connector means (16; 116A and B) at the second distal end of the first lateral wall (14), and further first connector means (18; 118A and B) positioned at the second distal end of the second lateral wall (15), and
the first and second connector means (17; 117A and B; 18; 118A and B; 19; 119A and B; 16; 116A and B) have co-operating interconnectable shapes such that each first connector means (17; 117A and B; 18; 118A and B) is shaped to be connectable to a further second connector means on another unit and each second connector means (19; 119A and B; 16; 116A and B) is shaped to be connectable to a further first connector means on another unit.

19. A unit according to Claim 17 or 18, wherein each connector means comprises a stepped portion of a lateral wall of a unit for engagement with a corresponding stepped portion of a lateral wall of another unit.

20. A unit according to Claim 19, wherein the stepped portions of units are shaped to engage stepped portions of adjacent units by overlapping.

## Patentansprüche

1. Modulares Gehäuse mit zwei Seiteneinheiten (1, 1') und einer Zwischeneinheit (10);
wobei jede Seiteneinheit (1) umfasst:
eine Seitenwand (1);
eine erste seitliche Wand (3), die sich senkrecht zur Seitenwand (2) an einem Ende derselben erstreckt;
eine zweite seitliche Wand (4), die sich senkrecht zur Seitenwand (2) an deren anderem Ende erstreckt sowie in dieselbe Richtung wie die erste seitliche Wand (3); und
eine Verbindungseinrichtung (5; 105A und B; 6; 106A und B) am distalen Ende jeder seitlichen Wand (3) zur Verbindung der Seiteneinheit (1) mit einer anderen Einheit zum Bilden eines Gehäuses (20);
wobei die Zwischeneinheit umfasst:
eine Zwischenwand (11);
eine erste seitliche Wand (14), die sich senkrecht zur Zwischenwand (11) an einem Ende derselben erstreckt und ein erstes distales Ende an einer Seite der Zwischenwand (11) und ein zweites distales Ende an der anderen Seite der Zwischenwand (11) hat;
eine zweite seitliche Wand (15), die sich senkrecht zur Zwischenwand (11) an deren anderem Ende erstreckt und ein erstes distales Ende an der genannten einen Seite der Zwischenwand (11) und ein zweites distales Ende an der genannten anderen Seite der Zwischenwand (11) hat; und
eine Verbindungseinrichtung (16; 116A und B; 17; 117A und B; 18; 118A und B; und 19; 119A und B) an den distalen Enden jeder seitlichen Wand (14, 15) zum Verbinden der Zwischeneinheit (10) mit anderen Einheiten zum Bilden eines Gehäuses;
**dadurch gekennzeichnet, dass** an jeder Seiteneinheit die Verbindungseinrichtung eine erste Verbindungsstückeinrichtung (5; 105A und B) am distalen Ende der ersten seitlichen Wand (3) und eine zweite Verbindungsstückeinrichtung (6; 106A und B) am distalen Ende der zweiten seitlichen Wand (4) an der Zwischeneinheit aufweist, wobei die Verbindungseinrichtung eine erste Verbindungsstückeinrichtung (17; 117A und B) an dem ersten distalen Ende der ersten seitlichen Wand (14), eine zweite Verbindungsstückeinrichtung (19; 119A und B) an dem ersten distalen Ende der zweiten seitlichen Wand (15), eine weitere zweite Verbindungsstückeinrichtung (16; 116A und B) an dem zweiten distalen Ende der ersten seitlichen Wand (14), und eine weitere erste Verbindungsstückeinrichtung (18; 118A und B) aufweist, die an dem zweiten distalen Ende der zweiten seitlichen Wand (15) angeordnet ist, und die erste und zweite Verbindungsstückeinrichtung (17; 117A und B; 18; 118A und B; 19; 119A und B; 16; 116A und B) zusammenwirkende verbindbare Formen haben, so dass jede erste Verbindungsstückeinrichtung (17; 117A und B; 18; 118A und B) so geformt ist, dass sie mit einer zweiten Verbindungsstückeinrichtung an einer anderen Einheit verbindbar ist, und jede zweite Verbindungsstückeinheit (19; 119A und B; 16; 116A und B) so geformt ist, dass sie mit einer ersten Verbindungsstückeinrichtung an einer anderen Einheit verbindbar ist.

2. Gehäuse nach Anspruch 1, wobei jede Seiteneinheit (1, 1') im wesentlichen identisch zu der anderen konstruiert ist, wobei jedoch eine Seiteneinheit relativ zur anderen umgekehrt ist.

3. Gehäuse nach Anspruch 1 oder 2, wobei das Gehäuse mindestens zwei Zwischeneinheiten (10, 10') wie in Anspruch 1 definiert aufweist.

4. Gehäuse nach Anspruch 3, wobei die Zwischeneinheiten im wesentlichen zueinander identisch sind.

5. Gehäuse nach einem der Ansprüche 1 bis 3, mit einer ersten Zwischeneinheit (10), die an einer Seite mit der ersten Seiteneinheit (1) in Eingriff ist, und einer zweiten Zwischeneinheit (10'), die an einer Seite mit der zweiten Seiteneinheit (1') in Eingriff ist, wobei die erste und zweite Zwischeneinheit (10, 10') miteineinander an ihren entsprechenden zweiten Seiten in Eingriff sind.

6. Gehäuse nach einem der Ansprüche 1 bis 3, mit einer ersten Zwischeneinheit (10), die an einer Seite mit der ersten Seiteneinheit (1) in Eingriff ist, einer zweiten Zwischeneinheit (10'), die an einer Seite mit der zweiten Seiteneinheit (1') in Eingriff ist, und mindestens einer dazwischen angeordneten weiteren Zwischeneinheit (10"), die in Eingriff mit der ersten und zweiten Zwischeneinheit (10, 10") ist.

7. Gehäuse nach einem der Ansprüche 1 bis 6, wobei die Seiten- und Zwischenwände (2, 1') benachbarte Abteilungen (26) des Gehäuses (20) definieren, wobei jede Abteilung (26) zwischen einer Seitenwand (2) und einer angrenzenden Zwischenwand (11) oder zwischen zwei angrenzenden Zwischenwänden (11, 11') definiert ist, wo mehrere Zwischeneinheiten (10, 10') vorgesehen sind.

8. Gehäuse nach Anspruch 7, wobei die Seiten- und Zwischenwände (2, 11) eine Einrichtung (7, 12) aufweisen, die mindestens zwei Unter-Abteilungen (21) innerhalb einer Abteilung (26) des Gehäuses (20) zur Aufnahme jeweils einer Vorrichtung (22, 23, 24) definieren.

9. Gehäuse nach einem der Ansprüche 1 bis 8, wobei die Dicken jeder Seitenwand (2, 2') und der oder jeder Zwischenwand (11, 11') im wesentlichen dieselben sind.

10. Gehäuse nach einem der vorhergehenden Ansprüche, wobei die Verbindungseinrichtung einen gestuften Abschnitt einer seitlichen Wand (14, 15) der oder jeder Zwischeneinheit zum Eingriff mit einem entsprechenden gestuften Abschnitt einer Wand der ersten Seiteneinheit (1), und/oder einer Wand der zweiten Seiteneinheit (1') und/oder einer Wand einer weiteren Zwischeneinheit (10') zwischen der ersten Zwischeneinheit und einer Seiteneinheit aufweist.

11. Gehäuse nach Anspruch 10, wobei die entsprechenden gestuften Abschnitte von angrenzenden Einheiten ineinander durch Überlappen eingreifen.

12. Gehäuse nach einem der vorhergehenden Ansprüche, wobei das Gehäuse zur Aufnahme einer Datenspeichervorrichtung ausgebildet ist.

13. Gehäuse nach einem der vorhergehenden Ansprüche, wobei mindestens eine der Seitenwände und Zwischenwände eine Einrichtung (7,12) zum Stützen einer Datenspeichervorrichtung in dem Gehäuse aufweist.

14. Datenspeichervorrichtung, die ein Gehäuse nach einem der Ansprüche 1 bis 13 aufweist, und weiterhin eine in dem Gehäuse enthaltene Datenspeichervorrichtung aufweist.

15. Vorrichtung nach Anspruch 14, wobei die Datenspeichervorrichtung ein Scheibenlaufwerk/Plattenlaufwerk ist.

16. Gehäuse nach einem der vorhergehenden Ansprüche, wobei:
die Seitenwand (2) der ersten Seiteneinheit (1) eine erste Seitenwand (2) des Gehäuses bereitstellt, wobei die Seitenwand (2') der zweiten Seiteneinheit (1') eine zweite Seitenwand (2') des Gehäuses gegenüberliegend und im wesentlichen parallel zur ersten Gehäuseseitenwand (2) bereitstellt; und die Zwischenwand (11) der oder jeder Zwischeneinheit (10) eine Zwischenwand (11) des Gehäuses zwischen der ersten und zweiten Seitenwand (2, 2') und im wesentlichen parallel zu diesen bereitstellt.

17. Seiteneinheit zur Verwendung mit einer oder mehr anderen Einheiten zum Bilden eines Gehäuses, wobei die Seiteneinheit (1) aufweist:
eine Seitenwand (2);
eine erste seitliche Wand (3), die sich senkrecht zur Seitenwand (2) an einem Ende derselben erstreckt,
eine zweite seitliche Wand (4), die sich senkrecht zur Seitenwand (2) am anderen Ende derselben und in dieselbe Richtung wie die erste seitliche Wand (3) erstreckt;
eine Verbindungseinrichtung (5, 6) am distalen Ende jeder seitlichen Wand (3) zum Verbinden der Seiteneinheit (1) mit einer weiteren Einheit zum Bilden eines Gehäuses (20);
**dadurch gekennzeichnet, dass** die Verbindungseinrichtung eine erste Verbindungsstückeinrichtung (5; 105A und B) am distalen Ende der ersten seitlichen Wand (3) und eine zweite Verbindungsstückeinrichtung (6; 106A und B) am distalen Ende der zweiten seitlichen Wand (4) aufweist; und
die erste und zweite Verbindungsstückeinrichtung (5; 105A und B; 6; 106A und B) zusammenwirkende miteinander verbindbare Formen haben, so dass die erste Verbindungsstückeinrichtung (5; 105A und B) so geformt ist, dass sie mit einer weiteren zweiten Verbindungsstückeinrichtung an einer anderen Einheit verbunden werden kann, und die zweite Verbindungsstückeinrichtung (6; 106A und B) so geformt ist, dass sie mit einer weiteren ersten Verbindungsstückeinrichtung an einer anderen Einheit verbunden werden kann.

18. Zwischeneinheit zur Verwendung mit anderen Einheiten zum Bilden eines Gehäuses, wobei die Zwischeneinheit aufweist:
eine Zwischenwand (11);
eine erste seitliche Wand (14), die sich senkrecht zur Zwischenwand (11) an einem Ende derselben erstreckt und ein erstes distales Ende an einer Seite der Zwischenwand (11) und ein zweites distales Ende an der anderen Seite der Zwischenwand (11) hat;
eine zweite seitliche Wand (15), die sich senkrecht zur Zwischenwand (11) am anderen Ende derselben erstreckt und ein erstes distales Ende an der genannten einen Seite der Zwischenwand (11) und ein zweites distales Ende an der genannten anderen Seite der Zwischenwand (11) hat;
eine Verbindungseinrichtung (16; 116A und B; 17; 117A und B; 18; 118A und B; und 19; 119A und B) an den distalen Enden jeder seitlichen Wand (14, 15) zum Verbinden der Zwischeneinheit (10) mit anderen Einheiten zum Bilden eines Gehäuses;
**dadurch gekennzeichnet, dass** die Verbindungseinrichtung eine erste Verbindungsstückeinrichtung (17; 117A und B) am ersten distalen Ende der ersten seitlichen Wand (14) aufweist, eine zweite Verbindungsstückeinrichtung (19; 119A und B) am ersten distalen Ende der zweiten seitlichen Wand (15), eine weitere zweite Verbindungsstückeinrichtung (16; 116A und B) an dem zweiten distalen Ende der ersten seitlichen Wand (14) und eine weitere erste Verbindungsstückeinrichtung (18; 118A und B), die an dem zweiten distalen Ende der zweiten seitlichen Wand (15) angeordnet ist, und
die erste und zweite Verbindungsstückeinrichtung (17; 117A und B; 18; 118A und B; 19; 119A und B; 16; 116A und B) zusammenwirkende miteinander verbindbare Formen haben, so dass jede erste Verbindungsstückeinrichtung (17; 117A und B; 18; 118A und B) so geformt ist, dass sie mit einer weiteren zweiten Verbindungsstückeinrichtung einer anderen Einheit verbindbar ist, und jede zweite Verbindungsstückeinrichtung (19; 119A und B; 16; 116A und B) so geformt ist, dass sie mit einer weiteren ersten Verbindungsstückeinrichtung an einer anderen Einheit verbindbar ist.

19. Einheit nach Anspruch 17 oder 18, wobei jede Verbindungsstückeinrichtung einen gestuften Abschnitt einer seitlichen Wand einer Einheit zum Eingriff mit einem entsprechenden gestuften Abschnitt einer seitlichen Wand einer weiteren Einheit aufweist.

20. Einheit nach Anspruch 19, wobei die gestuften Abschnitte der Einheiten so geformt sind, dass sie in gestufte Abschnitte von benachbarten Einheiten durch Überlappen eingreifen.

## Revendications

1. Boîtier modulaire comprenant deux unités intermédiaires (10);
chaque unité latérale (1) comprenant :
une paroi latérale (2);
une première paroi latérale (3) qui s'étend perpendiculairement à la paroi latérale (2), sur une extrémité de cette dernière;
une seconde paroi latérale (4), qui s'étend perpendiculairement à la paroi latérale (2) au niveau de l'autre extrémité de cette dernière et s'étend dans la même direction que la première paroi latérale (3); et
des moyens de raccordement (5;105A et B; 6; 106A et B) à l'extrémité distale de chaque paroi latérale (3) pour raccorder l'unité latérale (1) à une autre unité de manière à former un boîtier (20);
l'unité intermédiaire comprenant :
une paroi intermédiaire (11);
une première paroi latérale (14) qui s'étend perpendiculairement à la paroi intermédiaire (11), à une extrémité de cette dernière, et possède une première extrémité distale située d'un côté de la paroi intermédiaire (11) et une seconde extrémité distale située de l'autre côté de la paroi intermédiaire (11);
une seconde paroi latérale (15) qui s'étend perpendiculairement à la paroi intermédiaire (11), au niveau de son autre extrémité, et possédant une première extrémité distale sur ledit premier côté de la paroi intermédiaire (11) et une seconde extrémité distale sur ledit autre côté de la paroi intermédiaire (11); et
des moyens de raccordement (16;116A et B; 17; 117A et B; 18; 118A et B; et 19; 119A et B) au niveau des extrémités distales de chaque paroi latérale (14,15) pour le raccordement de l'unité intermédiaire (10) à d'autres unités de manière à former un boîtier;
**caractérisé en ce que** sur chaque unité latérale, les moyens de raccordement comprennent des premiers moyens formant connecteurs (5; 105A et B) sur l'extrémité distale de la première paroi latérale (3) et les seconds moyens formant connecteurs (6; 106A et B) sur l'extrémité distale de la seconde paroi latérale (4); et sur l'unité intermédiaire, les moyens de raccordement comprennent des premiers moyens formant connecteurs (17; 117A et B) sur la première extrémité distale de la première paroi latérale (14), des seconds moyens formant connecteurs (19; 119A et B) sur la première extrémité distale de la seconde paroi latérale (15); d'autres seconds moyens formant connecteurs (16; 116A et B) sur la seconde extrémité distale de la première paroi latérale (14) et d'autres premiers moyens formant connecteurs (18; 118A et B) positionnés sur la seconde extrémité distale de la seconde paroi latérale (15), et que les premiers et seconds moyens formant connecteurs (17; 117A et B; 18; 118A et B; 19, 119A et B; 16; 116A et B) possèdent des formes interconnectables coopérantes de telle sorte que chacun des premiers moyens formant connecteurs (17; 117A et B; 18; 118A et B) est conformé de manière à pouvoir être connecté à des seconds moyens formant connecteur sur l'autre unité, et que chacun des seconds moyens formant connecteurs (19; 119A et B; 16; 116A et B) sont conformés de manière à pouvoir être connectés à des premiers moyens formant connecteurs sur une autre unité.

2. Boîtier selon la revendication 1, dans lequel chaque unité latérale (1,1') est essentiellement identique à l'autre du point de vue construction, mais dans lequel une unité latérale est inverse par rapport à l'autre.

3. Boîtier selon la revendication 1 ou la revendication 2, dans lequel le boîtier inclut au moins deux unités intermédiaires (10,10') telles que définies dans la revendication 1.

4. Boîtier selon la revendication 3, dans lequel les unités intermédiaires sont essentiellement identiques entre elles.

5. Boîtier selon l'une quelconque des revendications 1 à 3, comprenant une première unité intermédiaire (10), qui engrène d'un côté avec la première unité latérale (11) et une seconde unité intermédiaire (10') qui engrène d'un côté avec la seconde unité latérale (1'), les première et seconde unités intermédiaires (10, 10') engrenant entre elles sur leurs seconds côtés respectifs.

6. Boîtier selon l'une quelconque des revendications 1 à 3, comprenant une première unité intermédiaire (10) engrenant d'un côté avec la première unité latérale (1), une seconde unité intermédiaire (10') engrenant d'un côté avec la seconde unité latérale (1') et au moins une autre unité intermédiaire (10") disposée entre et engrenant avec les première et seconde unités intermédiaires (10,10').

7. Boîtier selon l'une quelconque des revendications 1 à 6, dans lequel la paroi intermédiaire et la paroi latérale (2,1') définissent des baies adjacentes (26) du boîtier (20), chaque baie (27) étant définie entre une paroi latérale (2) et une paroi intermédiaire adjacente (11) ou entre deux parois intermédiaires adjacentes (11,11'), où plusieurs unités intermédiaires (10,10') sont prévues.

8. Boîtier selon la revendication 7, dans lequel la paroi latérale et la paroi intermédiaire (2,11) comportent des moyens (7,12) définissant au moins deux baies secondaires (21) à l'intérieur d'une baie (26) du boîtier (20) servant à recevoir chacune un dispositif (22,23,24).

9. Boîtier selon l'une quelconque des revendications 1 à 8, dans lequel les épaisseurs de chaque paroi latérale (2,2') et de la ou de chaque paroi intermédiaire (11, 11') sont essentiellement identiques.

10. Boîtier selon l'une quelconque des revendications précédentes, dans lequel les moyens de raccordement comprennent une partie étagée d'une paroi latérale (14,15) de la ou de chaque unité intermédiaire, destinée à engrener avec une partie conformée correspondante d'au moins l'une d'une paroi de la première unité latérale (1), une paroi de la seconde unité latérale (1') et une paroi d'une autre unité intermédiaire (10') entre ladite première unité intermédiaire et une unité latérale.

11. Boîtier selon la revendication 10, dans lequel les parties étagées respectives d'unités adjacentes engrènent réciproquement par chevauchement.

12. Boîtier selon l'une quelconque des revendications précédentes, dans lequel le boîtier est adapté pour loger un dispositif de mémorisation de données.

13. Boîtier selon l'une quelconque des revendications précédentes, dans lequel au moins l'une des parois latérales et des parois intermédiaires comportent des moyens (7,12) pour supporter un dispositif de mémorisation de données dans le boîtier.

14. Dispositif de mémorisation de données comprenant un boîtier selon l'une quelconque des revendications 1 à 13 et comprenant en outre un dispositif de mémorisation de données contenu dans ledit boîtier.

15. Dispositif selon la revendication 14, dans lequel le dispositif de mémorisation de données est une unité de disque.

16. Boîtier selon l'une quelconque des revendications précédentes, dans lequel :
la paroi latérale (2) de la première unité latérale (1) forme une première paroi latérale (2) du boîtier, la paroi latérale (2') de la seconde unité latérale (1') forme une seconde paroi latérale (2') du boîtier situé à l'opposé de la première paroi latérale du boîtier (2) et essentiellement parallèlement à cette paroi; et la paroi intermédiaire (11) de la ou de chaque unité intermédiaire (10) forme une paroi intermédiaire (11) du boîtier disposé entre les première et seconde parois latérales (2,2') et essentiellement parallèle à ces dernières.

17. Unité latérale destinée à être utilisée avec une ou plusieurs autres unités pour former un boîtier, l'unité latérale (1) comportant
une paroi latérale (2);
une première paroi latérale (3) s'étendant perpendiculairement à la paroi latérale (2), au niveau d'une de ses extrémités;
une seconde paroi latérale (4) s'étendant perpendiculairement à la paroi latérale (2), au niveau de son autre extrémité, et s'étendant dans la même direction que la première paroi latérale (3);
des moyens de raccordement (5,6) au niveau de l'extrémité distale de chaque paroi latérale (3) pour raccorder l'unité latérale (1) à une autre unité de manière à former un boîtier (20);
**caractérisé en ce que**
les moyens de connexion comprennent des premiers moyens formant connecteur (5; 105A et B) situés sur l'extrémité distale de la première paroi latérale (3), et des seconds moyens formant connecteur (6; 106A et B) sur l'extrémité distale de la seconde paroi latérale (A); et
les premiers et seconds moyens formant connecteurs (5; 105A et B; 6; 106A et B) possèdent des formes coopérantes interconnectables de telle sorte que les premiers moyens formant connecteur (5; 105A et B) sont conformés de manière à pouvoir être raccordés à d'autres seconds moyens formant connecteur sur une autre unité, et les seconds moyens formant connecteurs (6; 106A et B) sont conformés de manière à pouvoir être connectés à d'autres premiers moyens formant connecteur situé sur une autre unité.

18. Unité intermédiaire destinée à être utilisée avec d'autres unités pour former un boîtier, l'unité intermédiaire comprenant :
une paroi intermédiaire (11);
une première paroi latérale (14) s'étendant perpendiculairement à la paroi intermédiaire (11), à une extrémité de cette dernière, et comportant une première extrémité distale située sur un côté de la paroi intermédiaire (11) et une seconde extrémité distale située sur l'autre côté de la paroi intermédiaire (11);
une seconde paroi latérale (15) qui s'étend perpendiculairement à la paroi intermédiaire (11) au niveau de l'autre extrémité de cette dernière et possédant une première extrémité distale située sur ledit premier côté de la paroi intermédiaire (11) et une seconde extrémité distale située sur ledit autre côté de la paroi intermédiaire (11);
des moyens de connexion (16; 116A et B; 17; 117A et B; 18; 118A et B; et 19; 119A et B) au niveau des extrémités distales de chaque autre paroi latérale (14,15) pour connecter l'unité intermédiaire (10) à d'autres unités pour former un boîtier;
**caractérisé en ce que**
les moyens de connexion comprennent des premiers moyens formant connecteur (17; 117A et B) au niveau de la première extrémité distale de la première paroi latérale (14), des seconds moyens formant connecteur (19; 119A et B) au niveau de la première extrémité distale de la seconde paroi latérale (15), d'autres seconds moyens formant connecteur (16; 116A et B) sur la seconde extrémité distale de la première paroi latérale (14), et d'autres premiers moyens formant connecteur (18; 118A et B) positionnés sur la seconde extrémité distale de la seconde paroi latérale (15), et
les premiers et seconds moyens formant connecteur (17; 117A et B; 18; 118A et B) comportent des formes coopérantes interconnectables de telle sorte que les premiers moyens formant connecteur (17; 117A et B; 18; 118A et B) sont conformés de manière à pouvoir être raccordés à d'autres seconds moyens formant connecteur sur une autre unité, et les seconds moyens formant connecteurs(19; 119A et B; 16; 116A et B) sont conformés de manière à pouvoir être connectés aux autres premiers moyens formant connecteur situé sur l'autre unité.

19. Unité selon la revendication 17 ou 18, dans laquelle chacun des moyens formant connecteur comprend une partie étagée dune paroi latérale d'une unité destinée à engrener avec une partie étagée correspondante d'une paroi latérale d'une autre unité.

20. Unité selon la revendication 19, dans laquelle les parties étagées d'unités sont conformées de manière à engrener avec des parties étagées d'unités adjacentes, par chevauchement.
